Europäisches Patentamt

European Patent Office

Office européen des brevets

(11) Publication number: **0 079 211**
**B1**

# (12) EUROPEAN PATENT SPECIFICATION

(45) Date of publication of patent specification: **18.01.89**

(21) Application number: **82305890.4**

(22) Date of filing: **05.11.82**

(51) Int. Cl.⁴: **H 01 L 21/50,** H 01 L 23/04, H 01 L 23/48

(54) Package for semiconductor device and method for its production.

(30) Priority: **06.11.81 JP 177888/81**

(43) Date of publication of application:
**18.05.83 Bulletin 83/20**

(45) Publication of the grant of the patent:
**18.01.89 Bulletin 89/03**

(84) Designated Contracting States:
**DE FR GB**

(56) References cited:
EP-A-0 022 359
US-A-3 778 686
US-A-4 066 485

WESTERN ELECTRIC TECHNICAL DIGEST, Nr.
54, April 1979, pg 9-10, New York (US), C.R.
HERRING et al.:"Chip carrier with location
indicia"

PATENTS ABSTRACTS OF JAPAN, Vol.7,
Nr.115(E-176)(1260), May 19, 1983

(73) Proprietor: **FUJITSU LIMITED**
**1015, Kamikodanaka Nakahara-ku**
**Kawasaki-shi Kanagawa 211 (JP)**

(72) Inventor: **Kojima, Haruo**
**Tokyu-doeru 50-1 Shiratoridai**
**Midori-ku Yokohama-shi Kanagawa 227 (JP)**
Inventor: **Akasaki, Hidehiko**
**Howaito-haitsu 202 1-633 Marukodoori**
**Nakahara-ku Kawasaki-shi Kanagawa 211 (JP)**

(74) Representative: **Skone James, Robert Edmund**
**et al**
**GILL JENNINGS & EVERY 53-64 Chancery Lane**
**London WC2A 1HN (GB)**

## Description

The present invention relates to a package for a semiconductor device, particularly a mark structure for recognizing the location of a chip cavity, and to a method for producing such a package.

Recently, there has been a tendency to increase the integration of semiconductor integrated circuits, and, consequently, it has become necessary to enlarge the size of the semiconductor chip.

A semiconductor chip is mounted in a chip cavity of a ceramic package for a semiconductor device. The size of the chip cavity, in turn, is limited by the size of the package. Consequently, it is necessary that the clearance between the chip and the chip cavity be extraordinarily small in cases where a large scale integrated circuit chip is mounted on a conventional package.

In order to exactly recognize the location of a chip cavity, e.g., by means of a TV camera, marks are generally provided on the ceramic sheet of the package.

The term "alignment" and "mal-alignment" described hereinafter refer to the locational relationship between the chip cavity and the marks for recognising the chip cavity; in other words, to the relationship between the location of the produced marks and the designated location of the marks in respect to the location of the chip cavity, i.e. the window.

In prior art packages mal-alignment of the marks with respect to the chip cavity of up to ±0.2 mm occurs.

In accordance with one aspect of the present invention, a method of producing a package for a semiconductor comprises the steps of sequentially laminating three green ceramic sheets and firing the laminated green ceramic sheets, the lamination comprising the steps of providing a chip stage on an upper surface of the first sheet; superposing on the first green sheet the second green sheet provided with a first chip-inserting window for exposing the surface of the chip stage and provided with an internal conductor pattern formed at least on its upper surface and with marks being formed in the wire-bonding area of the second green sheet; and superposing on the second green sheet the third green sheet provided with a second window for exposing the first chip-inserting window and for exposing a portion of the internal conductor pattern as a wire-bonding area located adjacent to the periphery of the first chip-inserting window, characterised in that the first chip-inserting window and the marks for recognising the location of the first chip-inserting window are formed simultaneously, the first chip inserting window being formed by punching and the marks by either punching or pressing.

In accordance with a second aspect of the present invention, a package for a semiconductor device, comprises three sequentially laminated sheets, including a first ceramic sheet provided with a chip stage on its upper surface;

a second ceramic sheet provided with a first chip-inserting window exposing the chip stage and provided with an internal conductor pattern formed at least on its upper surface; and

a third ceramic sheet provided with a second window exposing the first chip-inserting window and a portion of the internal conductor pattern as a wire-bonding area located adjacent to the periphery of the first chip-inserting window, characterized in that

marks for recognizing the location of the first chip-inserting window have been punched or pressed on a part of the second ceramic sheet exposed by the second window and aligned relatively to the first chip-inserting window.

Preferably, the marks are punched through the second green ceramic sheet.

It is advantageous if the marks are intaglio pressed on the second green ceramic sheet.

It is convenient if the marks are circular or square.

Preferably, the first- chip-inserting window is foursided, the marks being located on a diagonal of the first chip-inserting window.

The package may be a dual in line type package, a plug in type package, or a leadless chip carrier type package or have external leads on one side or on all four sides.

An example of a method and package in accordance with the present invention will now be described and contrasted with two prior art examples with reference to the accompanying drawings,-in which:—

Figure 1 is a plan of a conventional package;

Figure 2 is an exploded view of the conventional package shown in Figure 1;

Figure 3 is a plan of another conventional package;

Figure 4 is a plan of an example according to the present invention;

Figure 5 is a section taken on the line A—A' in Figure 4; and

Figure 6 is an enlarged view of the example shown in Figure 4.

Two types of mark structures are known for recognizing the location of a cavity provided in a semiconductor package.

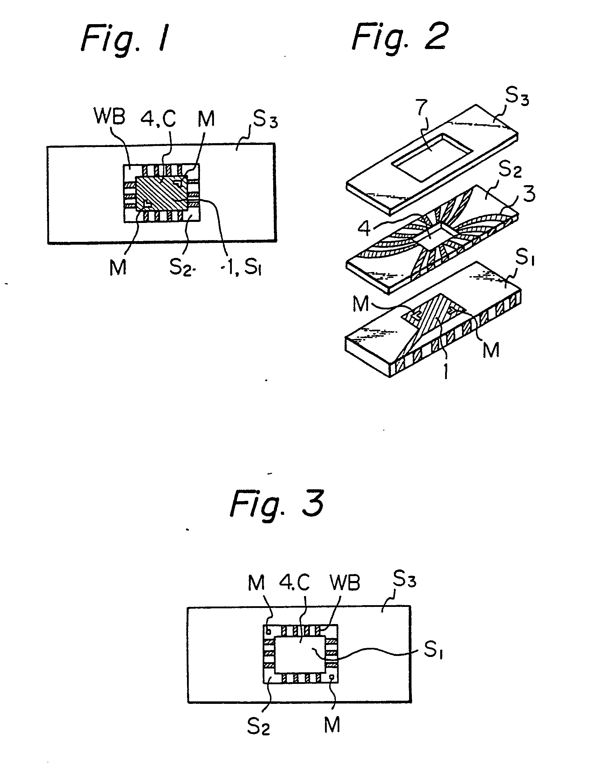

In Figure 1, marks M are formed within a metallized chip stage 1 on a first sheet $S_1$, in a chip cavity C. This structure can be explained in more detail referring to Figure 2. A first window 4 is opened in a second sheet $S_2$, on which an internal conductor pattern 3 is metallized so as to form a wire-bonding area WB. A second window 7 is opened in a third sheet $S_3$. The first window 4 and the second window 7 constitute the chip cavity C. These three ceramic sheets are laminated as green sheets and are fired to form a package for a semiconductor device.

In this prior art mark structure, two kinds of mal-alignment are apt to take place. One is due to inappropriate registration in metallizing the chip stage. The other is due to inappropriate lamination of the second sheet on the first sheet. Thus, the amount of mal-alignment of the marks in respect to the first window 4 amounts to ±0.2 mm.

In a second type of mark structure, the marks M are formed within the wire-bonding area WB on the second sheet $S_2$, in the chip cavity C (Figure 3). The marks M and the internal conductor pattern 3 are printed simultaneously on the second sheet $S_2$. Then, the first window 4 is punched through the second sheet $S_2$. Therefore, due to inappropriate registration between the printing and the punching, the mal-alignment of the marks in respect to the first window 4 amounts to ±0.1 mm.

Thus, the clearance between the chip and the chip cavity is inevitably limited by the amount of mal-alignment, i.e. ±0.1—0.2 mm.

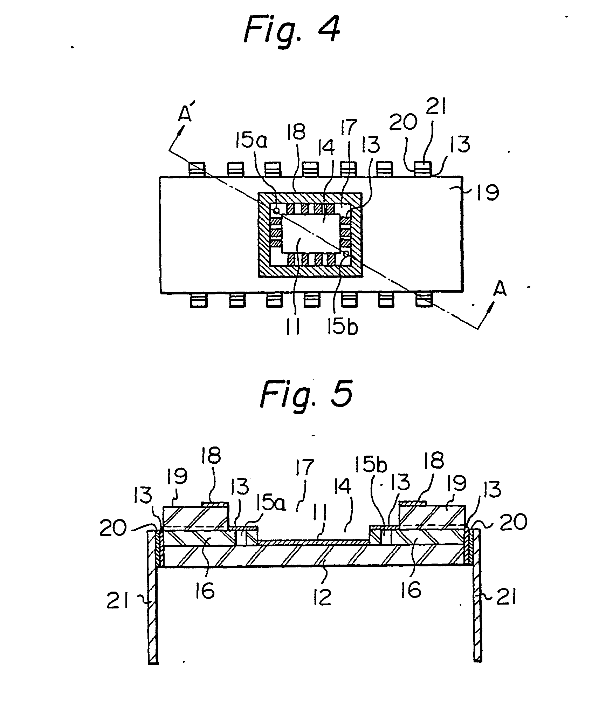

Figure 4 illustrates a plan of an example of a package according to the present invention. Figure 5 is a sectional view taken along the arrows "A" and "A'" in Figure 4. The package comprises three ceramic sheets 12, 16, and 19. The first sheet 12 is provided with a metallized chip stage 11, e.g., of gold. The second sheet 16 is provided with a metallized internal conductor pattern 13, e.g. of gold, a first chip-inserting window 14, and marks 15a and 15b for recognizing the location of the first chip-inserting window 14. The marks 15a and 15b are punched at the same time that the first chip-inserting window 14, which exposes the chip stage ·11, is punched, the marks 15a and 15b and the window 14 being punched by the same mold. The third sheet 19 is provided with a cap-brazing frame 18, e.g., of Au—Sn, and a second chip-inserting window 17, which exposes a portion of the internal conductor pattern 13 and the first window 14. This exposed portion of the pattern 13 constitutes a wire-bonding area, which surrounds the first window 14. A cap-brazing frame 18 surrounds the second window 17. The first and the second chip-inserting windows 14 and 17 constitute the chip-cavity, in which a chip is to be mounted. External leads 21 are fixed to a brazing material 20, e.g., of silver and are superposed on the extended portions of the internal conductor pattern 13.

Thus, marks 15a and 15b for recognizing the location of the first window 14 are formed in the wire-bonding area. The exposed surfaces of the external leads 21, the internal conductor pattern 13, and the chip stage 11 are usually plated, e.g., with gold.

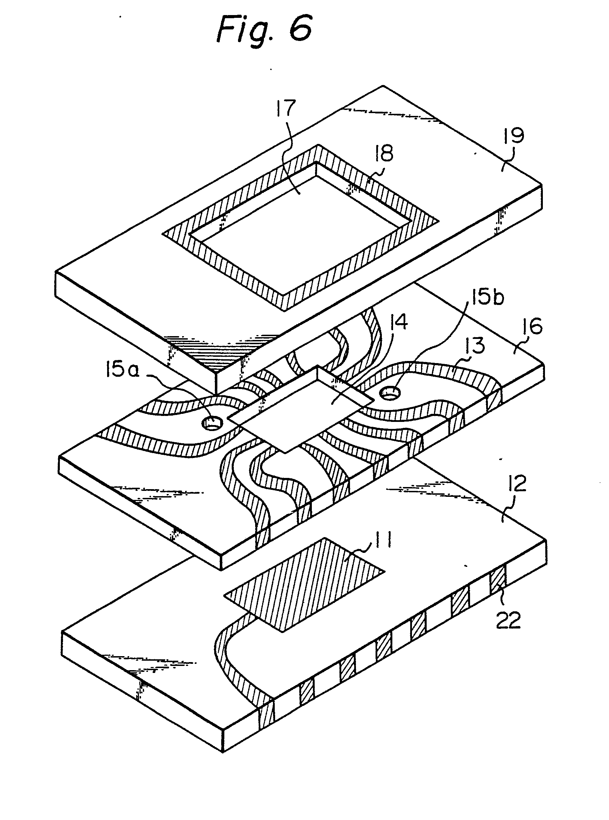

The structure of the package shown in Figures 4 and 5 will be more readily understood from the following description, referring to figure 6. As shown in the exploded view, the package for semiconductor devices comprises three ceramic sheets. The first sheet 12 has a conventional structure and is provided with the chip stage 11 and the metallized layer 22 in a conventional manner. The second sheet 16 is provided with the internal conductor pattern 13, the chip-inserting window 14, and the marks 15a and 15b. The window 14 and the marks 15a and 15b are simultaneously punched with the same mold through the second sheet 16. The third sheet 19 is provided with the second chip-inserting window 17 and the cap-brazing frame 18 metallized around the window 17 in a conventional manner.

## Claims

1. A method of producing a package for a semiconductor device, the method comprising the steps of sequentially laminating three green ceramic sheets (12, 16, 19) and firing the laminated green ceramic sheets, the lamination comprising the steps of providing a chip stage (11) on an upper surface of the first green sheet (12); superposing on the first green sheet (12) the second green sheet (16) provided with a first chip-inserting window (14) for exposing the surface of the chip stage (11) and provided with an internal conductor pattern (13) formed at least on its upper surface and with marks (15a, 15b) being formed in the wire-bonding area of the second green sheet (16); and superposing on the second green sheet (16) the third green sheet (19) provided with a second window (17) for exposing the first chip-inserting window (14) and for exposing a portion of the internal conductor pattern (13) as a wire-bonding area located adjacent to the periphery of the first chip-inserting window (14), characterised in that the first chip-inserting window (14) and the marks (15a, 15b) for recognising the location of the first chip-inserting window (14) are formed simultaneously in the second green sheet (16), the first chip inserting window (14) being formed by punching and the marks (15a, 15b) by either punching or pressing.

2. A method according to claim 1, wherein the marks (15a, 15b) and the first chip-inserting window (14) are formed with the same mold.

3. A method according to claim 1 or claim 2, characterised in that the marks (15a, 15b) are punched through the second green ceramic sheet (16).

4. A method according to claim 1, or claim 2, characterised in that the marks (15a, 15b) are intaglio formed on the second ceramic green sheet (16).

5. A package for a semiconductor device, the package comprising three sequentially laminated ceramic sheets (12, 16, 19) including, a first ceramic sheet (12) provided with a chip stage (11) on its upper surface; a second ceramic sheet (16) provided with a first chip-inserting window (14) exposing the chip stage (11) and provided with an internal conductor pattern (13) formed at least on its upper surface; and a third ceramic sheet (19) provided with a second window (17) exposing the first chip-inserting window (14) and a portion of the internal conductor pattern (13) as a wire-bonding area located adjacent to the periphery of the first chip-inserting window (14), characterised in that marks (15a, 15b) for recognising the location of the first chip-inserting window (14) have been punched or pressed on a part of the second ceramic sheet (16) exposed by the second window (17) and aligned relatively to the first chip-inserting window (14).

6. A package according to claim 5, characterised by being a dual-in line type package or a plug-in type package.

7. A package according to claim 5 or claim 6, characterised by having external leads on one side or on all four sides.

8. A package according to claim 5 or claim 6, characterised by being a leadless chip-carrier type package.

9. A package according to claim 5, characterised in that the first chip-inserting window (14) is foursided, the marks (15a, 15b) being located on a diagonal of the first chip-inserting window (14).


## Patentansprüche

1. Verfahren zur Herstellung einer Packung für eine Halbleitervorrichtung, welches Verfahren die Schritte des sequentiellen Laminierens dreier ungebrannter keramischer Blätter (12, 16, 19) und das Brenen der laminierten ungebrannten keramischen Blätter umfaßt, wobei das Laminieren die folgenden Schritte umfaßt: Vorsehen einer Chipbühne (11) auf einer oberen Oberfläche des ersten ungebrannten Blattes (12); Überlagern des ersten ungebrannten Blattes (12) mit dem zweiten ungebrannten Blatt (16), welches ein erstes Chip-Einsatz-Fenster (14) zum Exponieren der Oberfläche der Chipbühne (11) aufweist und mit einem internen Leitermuster (13) versehen ist, das wenigstens auf seiner oberen Oberfläche gebildet ist, und mit Marken (15a, 15b), die in dem Draht-Bonding-Bereich des zweiten ungebrannten Blattes (16) gebildet sind; und Überlagern des zweiten ungebrannten Blattes (16) mit dem dritten ungebrannten Blatt (19), welches ein zweites Fenster (17) zum Exponieren des ersten Chip-Einsatz-Fensters (14) und zum Exponieren eines Abschnittes des internen Leitermusters (13) als einen Draht-Bonding-Bereich aufweist, welcher neben dem Umfang des ersten Chip-Einsatz-Fensters (14) angeordnet ist, dadurch gekennzeichnet, daß das erste Chip-Einsatz-Fenster (14) und die Marken (15a, 15b) zur Wiedererkennung des Ortes des ersten Chip-Einsatz-Fensters (14) gleichzeitig in dem zweiten ungebrannten Blatt (16) gebildet werden, das erste Chip-Einsatz-Fenster (14) durch Stanzen gebildet wird und die Marken (15a, 15b) entweder durch Stanzen oder Pressen gebildet werden.

2. Verfahren nach Anspruch 1, bei dem die Marken (15a, 15b) und das erste Chip-Einsatz-Fenster (14) mit derselben Form gebildet werden.

3. Verfahren nach Anspruch 1 oder 2, dadurch gekennzeichnet, daß die Marken (15a, 15b) durch das zweite ungebrannte keramische Blatt (16) gestanzt werden.

4. Verfahren nach Anspruch 1 oder 2, dadurch gekennzeichnet, daß die Marken (15a, 15b) als Vertiefung in dem zweiten keramischen ungebrannten Blatt (16) ausgebildet sind.

5. Packung für eine Halbleitervorrichtung, welche Packung drei sequentiell laminierte keramische Blätter (12, 16, 19) umfaßt, ein erstes keramisches Blatt (12), welches eine Chipbühne (11) auf seiner oberen Oberfläche aufweist; ein zweites keramiches Blatt (16), welches ein erstes Chip-Einsatz-Fenster (14) aufweist, das die Chipstufe (11) exponiert und mit einem internen Leitermuster (13) versehen ist, welches wenigstens auf seiner oberen Oberfläche ausgebildet ist; und ein drittes keramisches Blatt (19), welches ein zweites Fenster (17) aufweist, das das erste Chip-Einsatz-Fenster (14) und einen Abschnitt des internen Leitermusters (13) als einen Draht-Bonding-Bereich exponiert, der neben dem Umfang des ersten Chip-Einsatz-Fensters (14) angeordnet ist, dadurch gekennzeichnet, daß Marken (15a, 15b) zum Wiedererkennen des Ortes des ersten Chip-Einsatz-Fensters (14) auf einem Teil des zweiten keramischen Blattes (16) gestanzt oder gepreßt sind, welches durch das zweite Fenster (17) exponiert und relativ zu dem ersten Chip-Einsatz-Fenster (14) ausgerichtet ist.

6. Packung nach Anspruch 5, dadurch gekennzeichnet, daß sie eine Packung vom dual-in-line-Typ oder eine Packung vom Einsteck-Typ ist.

7. Vorrichtung nach Anspruch 5 oder 6, dadurch gekennzeichnet, daß sie externe Leitungen auf einer Seite oder auf allen vier Seiten aufweist.

8. Packung nach Anspruch 5 oder 6, gekennzeichnet durch eine Packung vom leiterlosen Chip-Träger-Typ.

9. Packung nach Anspruch 5, dadurch gekennzeichnet, daß das erste Chip-Einsatz-Fenster (14) vierseitig ist, die Marken (15a, 15b) auf einer Diagonalen des ersten Chip-insatz-Fensters (14) angeordnet sind.


## Revendications

1. Procédé de production d'un boîtier destiné à un dispositif semiconducteur, le procédé comprenant les opérations consistant à séquentiellement stratifier trois feuilles de céramnique crue (12, 16, 19) et à cuire les feuilles de céramique crue stratifiées, la stratification comprenant les opérations consistant à produire un support (11) pour puce sur la face supérieure de la première feuille crue (12); à superposer à la première feuille crue (12) la deuxième feuille crue (16) dotée d'une première fenêtre (14) d'insertion de puce servant à exposer la surface du support (11) de puce et dotée d'une configuration de conducteurs interne (13) formée au moins sur sa face supérieure et de repères (15a, 15b) qui sont formés dans la zone de soudage de fils de la deuxième feuille crue (16); et à superposer à la deuxième feuille crue (16) la troisième feuille crue (19) dotée d'une deuxième fenêtre (17) servant à exposer la première fenêtre (14) d'insertion de puce et à exposer une partie de la configuration de conducteurs interne (13) faisant fonction de zone de soudage de fils placée au voisinage de la périphérie de la première fenêtre (14) d'insertion de puce, caractérisé en ce que la première fenêtre (14) d'insertion de puce et les repères (15a, 15b) servant à reconnaître la position de la première fenêtre (14) d'insertion de puce sont formés simultanément dans la deuxième feuille crue (16), la première fenêtre (14) d'insertion de puce étant formée par perforation et les repères (15a, 15b) étant formés par perforation ou pressage.

2. Le procédé selon la revendication 1, où les repères (15a, 15b) et la première fenêtre (14) d'insertion de puce sont formés à l'aide du même moule.

3. Procédé selon la revendication 1 ou 2, caractérisé en ce que les repères (15a, 15b) sont perforés au travers de la deuxième feuille de céramique crue (16).

4. Procédé selon la revendication 1 ou 2, caractérisé en ce que les repères (15a, 15b) sont formés par impression en taille-douce sur la deuxième feuille de céramique crue (16).

5. Boîtier pour dispositif semiconducteur, le boîtier comprenant trois feuilles de céramique séquentiellement stratifiées (12, 16, 19) comprenant une première feuille de céramique (12) dotée d'un support (11) de puce sur sa face supérieure; une deuxième feuille de céramique (16) dotée d'une première fenêtre (14) d'insertion de puce exposant le support (11) de puce et dotée d'une configuration de conducteurs interne (13) formée au moins sur sa face supérieure; et une troisième feuille de céramique (19) dotée d'une deuxième fenêtre (17) exposant la première fenêtre (14) d'insertion de puce et une partie de la configuration de conducteurs interne (13) faisant fonction d'une aire de soudage de fils située au voisinage de la périphérie de la première fenêtre (14) d'insertion de puce, caractérisé en ce que les repères (15a, 15b) servant à reconnaître la position de la première fenêtre (14) d'insertion de puce ont été perforés ou pressés sur une partie de la deuxième feuille de céramique (16) exposée par la deuxième fenêtre (17) et alignée relativement à la première fenêtre (14) d'insertion de puce.

6. Boîtier selon la revendication 5, caractérisé en ce qu'il est un boîtier du type double-ligne ou un boîtier du type enfichable.

7. Boîtier selon la revendication 5 ou 6, caractérisé en ce qu'il possède des conducteurs de cablage externes sur un côté ou sur les quatre côtés.

8. Boîtier selon la revendication 5 ou 6, caractérisé en ce qu'il est un boîtier du type à support de puce sans fil.

9. Boîtier selon la revendication 5, caractérisé en ce que la première fenêtre (14) d'insertion de puce est à quatre côtés, les repères (15a, 15b) étant placés sur une diagonale de la première fenêtre (14) d'insertion de puce.

# Fig. 1

WB  4,C   M      S₃

M      S₂·     ·1, S₁

# Fig. 2

7      S₃

S₂

3

4

M

S₁

M      1      M

# Fig. 3

M  4.C  WB   S₃

S₁

S₂      M

EP 0 079 211 B1

# Fig. 4

# Fig. 5

EP 0 079 211 B1

# Fig. 6